(19) Europäisches Patentamt / European Patent Office / Office européen des brevets

(11) **EP 2 443 469 B1**

(12) **EUROPÄISCHE PATENTSCHRIFT**

(45) Veröffentlichungstag und Bekanntmachung des Hinweises auf die Patenterteilung:
**21.01.2015 Patentblatt 2015/04**

(21) Anmeldenummer: **10726884.9**

(22) Anmeldetag: **18.05.2010**

(51) Int Cl.:
*G01R 31/3185* *(2006.01)*   *G01R 33/06* *(2006.01)*
*G01R 33/035* *(2006.01)*

(86) Internationale Anmeldenummer:
**PCT/DE2010/000561**

(87) Internationale Veröffentlichungsnummer:
**WO 2010/145631 (23.12.2010 Gazette 2010/51)**

(54) **ELEKTRISCHE WIDERSTANDSELEMENTE UND MESSSYSTEM ZUR MESSUNG ZEITVERÄNDERLICHER MAGNETISCHER FELDER ODER FELDGRADIENTEN**

ELECTRICAL RESISTANCE ELEMENTS AND MEASURING SYSTEM FOR MEASURING TIME-VARIABLE MAGNETIC FIELDS OR FIELD GRADIENTS

ÉLÉMENTS DE RÉSISTANCE ÉLECTRIQUE ET SYSTÈME DE MESURE POUR MESURER DES CHAMPS MAGNÉTIQUES OU DES GRADIENTS DE CHAMP MAGNÉTIQUE VARIANT DANS LE TEMPS

(84) Benannte Vertragsstaaten:
**AL AT BE BG CH CY CZ DE DK EE ES FI FR GB GR HR HU IE IS IT LI LT LU LV MC MK MT NL NO PL PT RO SE SI SK SM TR**

(30) Priorität: **20.06.2009 DE 102009025716**

(43) Veröffentlichungstag der Anmeldung:
**25.04.2012 Patentblatt 2012/17**

(73) Patentinhaber: **Forschungszentrum Jülich GmbH 52425 Jülich (DE)**

(72) Erfinder:
• **FALEY, Mikhail**
  **52428 Jülich (DE)**
• **POPPE, Ulrich**
  **52349 Düren (DE)**
• **FAGALY, Robert, L.**
  **San Diego, CA 92009 (US)**

(56) Entgegenhaltungen:
WO-A2-98/23969        DE-A1- 10 352 856
DE-C1- 19 839 935        DE-T2- 69 530 811

DE-U1- 29 620 718        US-A- 5 283 523
US-A1- 2006 147 154        US-A1- 2007 194 225

• HE D F ET AL: "N-14 NQR using a high-Tc rf SQUID with a normal metal transformer" SUPERCONDUCTOR SCIENCE AND TECHNOLOGY, IOP PUBLISHING, TECHNO HOUSE, BRISTOL, GB, Bd. 21, Nr. 1, 1. Januar 2008 (2008-01-01) , Seite 15023, XP020128582 ISSN: 0953-2048

• "Handbook of Chemistry & Physics Online!" 1. Januar 2010 (2010-01-01), CRC , XP002602600 Bd. 91, Seiten 12-72 - Seiten 12-73; Tabelle 3

• HIROYUKI OHSAKI ET AL: "Characteristics of Resistive Fault Current Limiting Elements Using YBCO Superconducting Thin Film With Meander-Shaped Metal Layer", IEEE TRANSACTIONS ON APPLIED SUPERCONDUCTIVITY, IEEE SERVICE CENTER, LOS ALAMITOS, CA, US, vol. 19, no. 3, 1 June 2009 (2009-06-01), pages 1818-1822, XP011262003, ISSN: 1051-8223

• HORI T ET AL: "Study of kV Class Current Limiting Unit With YBCO Thin Films", IEEE TRANSACTIONS ON APPLIED SUPERCONDUCTIVITY, IEEE SERVICE CENTER, LOS ALAMITOS, CA, US, vol. 17, no. 2, 1 June 2007 (2007-06-01), pages 1986-1989, XP011188247, ISSN: 1051-8223, DOI: 10.1109/TASC.2007.898449

EP 2 443 469 B1

**Beschreibung**

Die Erfindung betrifft ein Messinstrument für zeitveränderliche magnetische Felder oder Feldgradienten, elektrische Widerstandselemente, die als Kernkomponenten in dem Messinstrument verwendbar sind, sowie ein Messsystem mit einem erfindungsgemäßen Messinstrument oder elektrischen Widerstandselement.

Stand der Technik

Supraleitende          Quanteninterferometer (SQUIDs) sind die derzeit empfindlichsten Sensoren für magnetische Felder. Ihr Dynamikbereich ist jedoch beschränkt. Ist der Messort nicht nur vom zu messenden zeitveränderlichen magnetischen Feld durchsetzt, sondern auch von einem um mehrere Größenordnungen höheren statischen oder nur sehr langsam veränderlichen Störfeld, so gerät der Sensor allein durch das Störfeld oft in die Sättigung. Das eigentliche Messsignal ist nur eine sehr kleine Modulation auf einem hohen Hintergrundsignal, das durch das Störfeld bewirkt wird.

Um das Messsignal vom Hintergrundsignal zu trennen, werden Flusstransformatoren eingesetzt. Diese verwandeln durch eine Aufnehmerspule (Pick-up-Spule) den zeitveränderlichen Anteil des magnetischen Flusses, der durch das zu messende Feld in dieser Pick-up-Spule erzeugt wird, in einen elektrischen Strom. Dieser Strom speist eine Magnetfeldquelle, in der Regel eine Spule (Einkoppelspule), die daraufhin ein magnetisches Hilfsfeld erzeugt. Dieses Hilfsfeld wird vom eigentlichen Sensor, in der Regel einem SQUID, gemessen.

Dabei werden für die empfindlichsten Messungen bei niedrigen Frequenzen in der Regel supraleitende Flusstransformatoren eingesetzt, um Signalverluste zu minimieren (J. E. Zimmermann, N. V. Frederick, "Miniature Ultrasensitive Superconducting Magnetic Gradiometer and Its Use in Cardiography and Other Applications", Appl. Phys. Lett. 19, 16 (1971)). Nachteilig reichern sich im Stromkreis aus Pick-up-Spule und Magnetfeldquelle sukzessive Störanteile an, die von starken statischen sowie sehr langsam veränderlichen (Zeitkonstante > 10 min) magnetischen Störfeldern herrühren. Dynamikbereich und Empfindlichkeit des Messsystems werden hierdurch progressiv verschlechtert.

Normalleitende   Flusstransformatoren   sind beispielsweise aus (T. Q. Yang, Kenichiro Yao, Daisuke Yamaski, Keiji Enpuku, "Magnetometer utilizing SQUID picovoltmeter and cooled normal pickup coil", Physica C 426-431, 1596-1600 (2005)) und (D. F. He, H. Itozaki, M. Tachiki, "Improving the sensitivity of a high-TC SQUID at MHz frequency using a normal metal transformer", Superconductor Science and Technology 19, S231-S234 (2006)) bekannt. Nachteilig weisen diese Flusstransformatoren zu kurze Relaxationszeitkonstanten von etwa 10 μs auf, so dass bei tiefen Frequenzen unterhalb von etwa 100 kHz zu hohe Verluste auftreten und die erzielten Messergebnisse daher nicht mehr aussagefähig sind.

Zugleich beaufschlagen sie in diesem Frequenzbereich das Messsignal mit einem großen Rauschen.

Aus (H. Dyvorne, J. Scola, C. Fermon, J. F. Jacquinot, M. Pannetier-Lecoeur, "Flux transformers made of commercial high critical temperature superconducting wires", Review of Scientific Instruments 79, 025107 (2008)) ist ein Flusstransformator bekannt, dessen Pick-Up-Spule und Einkoppelspule jeweils aus bandförmigen Drähten bestehen und durch eine bandförmige Doppelleitung miteinander verbunden sind. Durch die normalleitenden Lötstellen zwischen den Spulen und der Doppelleitung werden die sich in supraleitenden Spulen anreichernden Störanteile dissipiert. Nachteilig ist die Empfindlichkeit dieser Anordnung insbesondere für bio- und geomagnetische Messungen unzureichend.

Aufgabe und Lösung

Es ist daher die Aufgabe der Erfindung, ein Messinstrument und ein Verfahren zur Verfügung zu stellen, mit denen zeitveränderliche magnetische Felder oder Feldgradienten bei tiefen wie hohen Frequenzen, mit einer in einem weiteren Bereich wählbaren Zeitkonstanten sowie mit einer höheren Empfindlichkeit bei gleichzeitig geringerem Rauschen gemessen werden können als dies nach dem Stand der Technik möglich war.

Diese Aufgaben werden erfindungsgemäß gelöst durch ein Messinstrument gemäß Hauptanspruch, durch elektrische Widerstandselemente, die als Kernkomponenten in dem Messinstrument verwendbar sind, gemäß Nebenansprüchen sowie durch ein Messsystem gemäß weiterem Nebenanspruch. Weitere vorteilhafte Ausgestaltungen ergeben sich jeweils aus den darauf rückbezogenen Unteransprüchen.

Gegenstand der Erfindung

Im Rahmen der Erfindung wurde ein Messinstrument für zeitveränderliche magnetische Felder oder Feldgradienten entwickelt. Dieses Messinstrument weist einen Flusstransformator auf. Der Flusstransformator weist eine Leiterschleife ("Pick-up-Spule") mit einem Basismaterial, das einen Phasenübergang zum supraleitenden Zustand besitzt, zur Umwandlung eines zeitveränderlichen magnetischen Flusses oder Flussgradienten in einen elektrischen Strom sowie eine aus dieser Leiterschleife gespeiste Magnetfeldquelle zur Umwandlung des elektrischen Stroms in ein magnetisches Hilfsfeld auf. Dabei besitzt das Material der Magnetfeldquelle vorteilhaft ebenfalls einen Phasenübergang zum supraleitenden Zustand. Der zeitveränderliche magnetische Fluss oder Flussgradient wird vorteilhaft nur von dem zeitveränderlichen Anteil des zu messenden Magnetfeldes oder Magnetfeldgradienten erzeugt. Das Messinstrument weist einen Sensor, wie beispielsweise ein SQUID, für das magnetische Hilfsfeld auf.

Der Flusstransformator weist auch dann, wenn sich das Basismaterial im supraleitenden Zustand befindet, mindestens einen resistiven Bereich (auch "Verbraucherbereich" genannt) mit von Null verschiedenem elektrischem Widerstand zur Dissipation der elektrischen Energie in dem Stromkreis auf, der die Leiterschleife und die Magnetfeldquelle umfasst. Dabei kann der Verbraucherbereich auch die Leiterschleife, die Magnetfeldquelle oder Teilbereiche der Leiterschleife oder der Magnetfeldquelle umfassen. Diese Ausgestaltung ist beispielsweise vorteilhaft, wenn die Leiterschleife oder die Magnetfeldquelle ein Typ-II-Supraleiter ist und in der jeweiligen Anwendung zwar im supraleitenden Zustand, jedoch oberhalb ihres ersten kritischen Magnetfelds beziehungsweise ersten kritischen Stroms betrieben wird. Dann wird das supraleitende Material von Abrikosov-Flussschläuchen durchsetzt. Sind diese beweglich, so wird für diese mit Reibung verbundene Bewegung Energie benötigt, die sich als von Null verschiedener Widerstand auswirkt. Im Regelfall unterscheidet sich der Verbraucherbereich jedoch von der Leiterschleife und der Magnetfeldquelle. Der Verbraucherbereich besteht dann aus nichtsupraleitendem Material und ist etwa seriell in den Leiterschleife und Magnetfeldquelle umfassenden Stromkreis eingebunden.

Erfindungsgemäß sind die Leiterschleife und die Magnetfeldquelle in einer Ebene angeordnet. Dabei können die Leiterschleife und/oder die Magnetfeldquelle insbesondere als planare Strukturen von dünnen Schichten mit einer Schichtdicke von etwa 1 μm oder weniger ausgebildet sein. Insbesondere wenn das Basismaterial der Leiterschleife und/oder das Material der Magnetfeldquelle ein Hochtemperatursupraleiter ist, ist es vorteilhaft, wenn Leiterschleife und/oder die Magnetfeldquelle als epitaktische supraleitende Schichten auf einkristallinen Substraten ausgebildet sind. Solche Schichten können beispielsweise mit Fotolithografie strukturiert werden. Eine Ausgestaltung der Leiterschleife und/oder Magnetfeldquelle als Dünnschichtstruktur verbessert vorteilhaft die Empfindlichkeit des Messinstruments und verringert das Rauschen.

Die von Dyvorne et al. verwendeten supraleitenden Drähte und Bänder lassen sich nur schwer zu planaren Strukturen aus dünnen Schichten umarbeiten.

Die Anordnung in einer Ebene ist nicht in der Weise einschränkend zu verstehen, dass die Leiterschleife und die Magnetfeldquelle auf dem gleichen Substrat angeordnet sein müssen. Beispielsweise können die Leiterschleife und die Magnetfeldquelle auf separaten Substraten strukturiert sein, die mit ihren strukturierten Oberflächen aneinandergefügt und elektrisch verbunden sind ("flip-chip"-Technologie). Dabei kann insbesondere auf einem Substrat oder auf beiden Substraten eine normalleitende Schicht angeordnet sein. Die hieraus beim Zusammenfügen der Substrate zwischen beiden Substraten gebildete Zwischenschicht kann insbesondere dann vorteilhaft als Verbraucherbereich zwischen der Leiterschleife und der Magnetfeldquelle fungieren, wenn sowohl die Leiterschleife als auch die Magnetfeldquelle aus hochtemperatursupraleitenden Materialien gefertigt sind. Damit werden die Schwierigkeiten, die üblicherweise bei der Kontaktierung keramischer Hochtemperatursupraleiter mit normalleitenden Metallen auftreten, vorteilhaft überwunden. Bestehen die Leiterschleife und die Magnetfeldquelle dagegen aus tieftemperatursupraleitenden Materialien, so ist es vorteilhafter, die elektrische Verbindung zwischen beiden Substraten supraleitend auszuführen und den Verbraucherbereich auf einem der Substrate oder auf beiden Substraten zu realisieren. Diese Art der Fertigung ist technologisch kontrollierbarer und reproduzierbarer als das Einbringen einer normalleitenden Zwischenschicht zwischen beide Substrate.

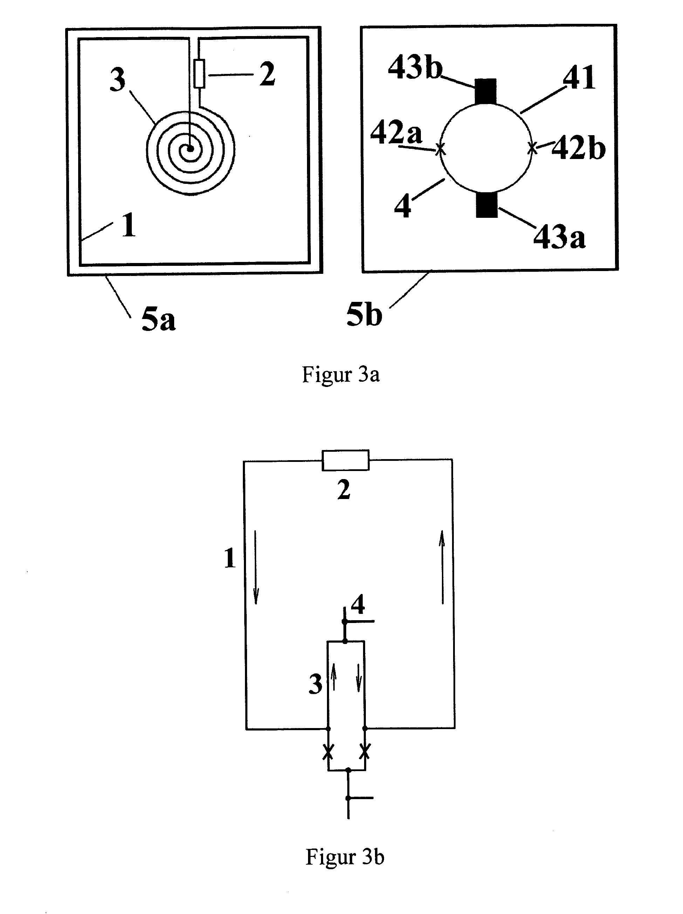

Durch die Kombination der supraleitenden Leiterschleife mit dem nichtsupraleitenden Verbraucherbereich lassen sich sehr kleine Widerstandswerte in dem Stromkreis realisieren, der die Leiterschleife und die Magnetfeldquelle umfasst. Der Gleichstrom-Widerstandswert lässt sich so nahe an Null heran maßschneidern, dass gerade noch mit einer für die jeweilige Anwendung relevanten Relaxationszeit Energie aus dem Stromkreis dissipiert wird. Dieser Prozess wurde bei Dyvorne et al beobachtet. Jedoch war die Empfindlichkeit der von Dyvorne et al. offenbarten Anordnung insbesondere für bio- und geomagnetische Messungen nicht ausreichend, weil nur ein Bruchteil des magnetischen Flusses, der die Pickup-Spule durchsetzte, an die Einkoppelspule übermittelt wurde (siehe Figur 3 in Dyvorne et al. mit zugehöriger Beschreibung). Es wurde nun erkannt, dass durch die erfindungsgemäße Anordnung von Leiterschleife und Magnetfeldquelle in einer Ebene die Verluste an magnetischem Fluss auf dem Weg von der Leiterschleife zur Magnetfeldquelle vorteilhaft verringert werden können. In dieser Geometrie lässt sich die Leitungslänge zwischen der Leiterschleife und der Magnetfeldquelle vorteilhaft minimieren. Zugleich lässt sie sich so ausführen, dass ihre Induktivität pro Einheit Länge minimiert wird. Beispielsweise können Hin- und Rückleitung zwischen Leiterschleife und Magnetfeldquelle so nahe beieinander strukturiert sein, dass zwischen diesen Leitungen nur eine sehr geringe Fläche eingeschlossen ist. Insbesondere können die Hin- und Rückleitung übereinander gestapelt sein, wobei sie durch eine dünne isolierende Schicht getrennt sind.

Es wurde erkannt, dass auf diese Weise die Gesamtinduktivität der Leitung zwischen Leiterschleife und Magnetfeldquelle minimiert werden kann. Diese Induktivität ist maßgeblich für den parasitären magnetischen Fluss, den die Leitung zwischen Leiterschleife und Magnetfeldquelle beim Durchgang des Stroms von der Leiterschleife zur eigentlichen Magnetfeldquelle erzeugt. Je höher dieser parasitäre Fluss ist, desto geringer ist das von der Magnetfeldquelle erzeugte Hilfsfeld, das vom Sensor registriert werden kann.

Die Leiterschleife kann insbesondere eine Spule aus einem Draht oder einer Dünnschicht mit einer oder mehreren Windungen sein. Diese Ausführungsform wird im Folgenden auch als Pick-up-Spule bezeichnet. Die Magnetfeldquelle kann insbesondere eine Spule aus einem Draht oder einer Dünnschicht mit einer oder mehreren Windungen sein. Diese Ausführungsform wird im Folgenden auch als Einkoppelspule bezeichnet. Vorteilhaft weisen die Pick-up-Spule und/oder die Einkoppelspule mehrere Windungen auf. Dies vergrößert jeweils die Induktivität und damit das Übersetzungsverhältnis zwischen dem zu messenden Feld oder Feldgradienten und dem elektrischen Strom in der Pick-up-Spule.

Vorteilhaft weist die Pick-up-Spule einen Durchmesser von 1 cm oder mehr, bevorzugt von 3 cm oder mehr und ganz besonders bevorzugt von 5 cm oder mehr, auf. Speziell in Verbindung mit einer weiteren vorteilhaften Ausgestaltung, in der die Einkoppelspule einen Durchmesser von 3 mm oder weniger aufweist, hat eine solche Größe die Wirkung, dass der vom zu messenden Magnetfeld oder Magnetfeldgradienten bewirkte Fluss bei der Übertragung von der Pick-up-Spule zur Einkoppelspule flächenmäßig konzentriert und daher das magnetische Feld am Sensor verstärkt wird. Ein solchermaßen verstärktes magnetisches Feld kann von dem Sensor zuverlässiger von äußeren Störfeldern unterschieden werden, was die Genauigkeit der Messung verbessert. Beispiele für solche Störfelder sind das Erdmagnetfeld und Magnetfelder, die von Strom führenden Leitungen ausgehen. Generell ist es im Interesse einer großen Verstärkung des Feldes vorteilhaft, wenn das Verhältnis der Durchmesser von Einkoppelspule und Pick-up-Spule höchstens 0,1 beträgt. Dies wurde bei Dyvorne et al. nicht erreicht.

Ein Durchmesser der Einkoppelspule von 3 mm oder weniger führt zu einer besseren Magnetfeldverstärkung des Flusstransformators und einer besseren Kopplung zum Sensor, weil dies der maximalen Größe der sensitiven Zone üblicher empfindlicher Magnetfeldsensoren entspricht. Bei diesen Sensoren wird die sensitive Zone bewusst klein gehalten, um das Eigenrauschen (insbesondere bei SQUIDs) und Störungen zu minimieren. Außerdem lässt sich eine kleine sensitive Zone überproportional besser gegen äußere Magnetfelder abschirmen als eine größere sensitive Zone. Zudem leistet ein großräumig verteiltes Störfeld, wie beispielsweise das Erdmagnetfeld, einen umso geringeren Beitrag zum Messsignal, je kleiner die sensitive Zone ist. Im Interesse einer hohen Verstärkung können auch Durchmesser der Einkoppelspule bis hinab zu 100 $\mu$m sinnvoll sein. Dies ist hauptsächlich mit photolithografisch strukturierten mehrlagigen Einkoppelspulen mit vielen Windungen aus dünnen Schichten auf einem planaren Substrat möglich.

Vorteilhaft weist die Einkoppelspule zwischen 80 % und 120 % der Induktivität der Pick-Up-Spule, insbesondere die gleiche Induktivität wie die Pick-up-Spule, auf. Dann wird der vom zu messenden Magnetfeld oder Magnetfeldgradienten erzeugte magnetische Fluss in der Pick-up-Spule am effizientesten in ein von der Einkoppelspule ausgehendes Magnetfeld umgesetzt. Weisen Einkoppelspule und Pick-up-Spule verschiedene Durchmesser auf, sind die Windungszahlen entsprechend anzupassen, um gleiche Induktivitäten zu realisieren. Die Induktivität einer Spule ist etwa linear in ihrem Durchmesser und quadratisch in ihrer Windungszahl. Vorteilhaft ist das Verhältnis der Windungszahlen von Einkoppelspule und Pick-up-Spule daher mindestens so groß wie die Quadratwurzel des Verhältnisses der Durchmesser von Einkoppelspule und Pick-Up-Spule (im Folgenden q genannt). Ist das Verhältnis der Windungszahlen genau gleich q, ist das magnetische Feld am Sensor gegenüber dem Feld in der Pick-up-Spule maximal verstärkt. Dabei können Verstärkungsfaktoren um etwa 100 realisiert werden.

Mit den von Dyvorne et al. verwendeten bandförmigen Supraleitern kann ein Durchmesser der Einkoppelspule von 3 mm oder weniger nicht realisiert werden, da diese Supraleiter ihre Supraleitung einbüßen, wenn sie in Radien unter 5 mm gebogen werden (Sektion "Experimental" in Dyvorne et al.).

In einer besonders vorteilhaften Ausgestaltung der Erfindung ist die Magnetfeldquelle zumindest teilweise innerhalb des von der Leiterschleife umschlossenen Bereichs angeordnet. In einer solchen Anordnung ist eine besonders kurze Leitungslänge zwischen Leiterschleife und Magnetfeldquelle realisierbar. Im Idealfall kann die Magnetfeldquelle so in die Leiterschleife integriert sein, dass außer der ohnehin vorhandenen Leiterschleife überhaupt keine zusätzliche Zuleitung für die Magnetfeldquelle erforderlich ist.

Die Zeitkonstante kann vorteilhaft in einem weiten Bereich von etwa 1 ms bis etwa $10^6$ s gewählt werden. Der Verbraucherbereich weist hierzu vorteilhaft einen elektrischen Widerstand zwischen $10^{-11}$ $\Omega$ und $10^{-5}$ $\Omega$, bevorzugt zwischen $10^{-11}$ $\Omega$ und $10^{-6}$ $\Omega$, auf.

Ein Widerstand in der Größenordnung 1 $\Omega$, wie er bei normalleitenden Flusstransformatoren typisch ist, verschlechterte die Messgenauigkeit allein schon durch sein thermisches Rauschen (Nyquist-Rauschen). Bei Frequenzen unterhalb von 1 kHz konnte die Magnetfeldmessung im Endergebnis nur mit einem Rauschen von mindestens 10 pT/Hz$^{1/2}$ erfolgen, so dass etwa bio- oder geomagnetische Messungen nur stark eingeschränkt möglich waren. Auch lag die Relaxationszeit für den umlaufenden Strom, die sich als Quotient aus der Gesamtinduktivität und dem Gesamtwiderstand des Stromkreises ergibt, bei typischen Induktivitäten zwischen 10 nH und 100 $\mu$H unterhalb von 10 $\mu$s. Dies war für viele Anwendungen zu kurz.

War der Flusstransformator dagegen vollständig supraleitend, mit einem Widerstand von praktisch 0 $\Omega$ bis zu einer Genauigkeit von etwa $10^{-20}$ $\Omega$, so wurde in ihm in diesem Zustand überhaupt keine Energie dissipiert. Jede auch noch so langsame Veränderung von störenden äußeren Magnetfeldern oder Magnetfeldgradienten wurde daher in Form von elektrischer Energie in ihr aufkumuliert. Diese Energie wurde erst dann vollständig im Flusstransformator dissipiert, wenn das supraleitende Material über seine Sprungtemperatur erwärmt wurde. Sie wurde in der Regel nur teilweise dissipiert, wenn der kritische Strom des supraleitenden Materials kurzzeitig überschritten wurde. Wurden etwa für geomagnetische Magnetfeldmessungen von, zum Beispiel, einem Hubschrauber aus durchgeführt und änderte dieser beim Wenden seine Orientierung gegenüber dem Erdmagnetfeld, so war der Flusstransformator in der Regel erst nach Aufwärmen und erneutem Abkühlen wieder messbereit.

Das erfindungsgemäße Messinstrument behebt beide Nachteile, ohne dass dies mit einem Verlust an Empfindlichkeit erkauft werden muss. Die in diesem Messinstrument verwendeten rauscharmen Widerstände mit sehr kleinen, jedoch von Null verschiedenen Widerstandswerten kann man nicht nur für Flusstransformatoren und Sensoren, sondern auch für mehrere andere Strukturen der supraleitenden Elektronik, zum Beispiel RSFQ oder Quantencomputer, anwenden.

Der Induktivität L des Flusstransformators setzt sich aus der Summe der Induktivitäten von Pick-up-Spule, Einkoppelspule und von allen Verbindungen zusammen. Vorteilhaft weist der Flusstransformator insgesamt eine Induktivität L zwischen 1 nH und 1 mH, bevorzugt zwischen 10 nH und 100 $\mu$H, auf. Eine Induktivität in diesem Bereich ist besonders geeignet, um eine weitere besonders vorteilhafte Ausgestaltung der Erfindung zu realisieren. In dieser weiteren besonders vorteilhaften Ausgestaltung hat ein im Flusstransformator zirkulierender elektrischer Strom mindestens dann, wenn sich das Basismaterial im supraleitenden Zustand befindet, eine Relaxationszeit $\tau$ zwischen 1 ms und $10^6$ s, bevorzugt zwischen 3 ms und 300 s. Eine derartige verfügbare Auswahl an Relaxationszeiten bewirkt, dass mit dem erfindungsgemäßen Messinstrument sowohl schnelle Phänomene auf einer Frequenzskala um 1 MHz als auch Magnetfelder und Magnetfeldgradienten gemessen werden können, die sich mit Frequenzen der Größenordnung $1/(2\pi\tau)$ ändern. Für eine aussagekräftige Messung ist es jeweils erforderlich, innerhalb der Relaxationszeit eine Mindestanzahl von Schwingungen erfassen zu können. Für die Empfindlichkeit des Messsystems ist besonders wichtig, dass das Nyquist-Rauschen des Verbraucherbereiches stark bei Frequenzen oberhalb von $1/(2\pi\tau)$ sinkt.

Der Flusstransformator ist effektiv ein RL-Kreis für die zeitvariablen Signale. In diesem RL-Kreis ist R ist der elektrische Widerstand des Verbraucherbereiches, und L ist die Induktivität des Flusstransformators. Für die Zeitkonstante $\tau$ dieses RL-Kreises ist sein Gesamtwiderstand ein entscheidender Parameter. Je geringer der Widerstand R des Verbraucherbereichs, desto größer ist die Zeitkonstante $\tau = L/R$ und desto geringer ist die minimale Frequenz ("Abschneidefrequenz") $f_0 = R/(2\pi L) = 1/(2\pi\tau)$, die mit dem Messinstrument gemessen werden kann. Die in dem Messinstrument realisierten Widerstandswerte nahe Null erweitern den Frequenzbereich im Vergleich zu den Messungen mit normalleitenden Flusstransformatoren bis zu unteren Abschneidefrequenzen $f_0 \approx 1$ Hz oder sogar darunter. Somit kann mit diesem Messinstrument der volle Frequenzbereich von weniger als 1 Hz bis etwa 1 MHz abgedeckt werden, wobei die obere Grenze des Frequenzbereiches keine physikalische Grenze ist, sondern nur durch die Verfügbarkeit entsprechend schneller Steuerelektronik vorgegeben ist.

In einer besonders vorteilhaften Ausgestaltung der Erfindung ist die Übertragungsfunktion des Flusstransformators, welche die Umwandlung des zu messenden Feldes oder Feldgradienten in das Hilfsfeld beschreibt, ein Hochpass. Dieser weist vorteilhaft eine Abschneidefrequenz $f_0$ zwischen 1 $\mu$Hz und 1 kHz, bevorzugt zwischen 3 mHz und 300 Hz, auf. Dann hat der Flusstransformator gegenüber einer direkten Messung des zu messenden Feldes ohne Umweg über ein Hilfsfeld die Wirkung, dass speziell statische oder langsam veränderliche störende Magnetfelder bzw. Magnetfeldgradienten nicht zum Hilfsfeld beitragen und somit auch nicht mitgemessen werden. Somit wird verhindert, dass ein empfindlicher Sensor allein schon durch die Störfelder physisch an die Grenze der Sättigung gerät und das eigentliche Messsignal nur eine kleine Modulation auf einem hohen Sockelsignal ist. Durch die physikalische Abtrennung der Störfelder noch vor dem Sensor können Dynamik und Empfindlichkeit des Sensors in vollem Umfang für den zu messenden zeitvariablen Anteil des magnetischen Feldes genutzt werden. Dies ist besonders vorteilhaft für bio- und geomagnetische Messungen sowie für die zerstörungsfreie Materialprüfung und Materialforschung. Bei diesen Messungen treten zudem Signale aus einem breiten Frequenzband auf. Für diese Messungen ist daher eine weitere Ausgestaltung der Erfindung besonders vorteilhaft, in der die Übertragungsfunktion des Flusstransformators, die die Umwandlung des zu messenden Feldes in das Hilfsfeld beschreibt, für Frequenzen zwischen der Abschneidefrequenz $f_0$ des Hochpasses und 1 MHz durchlässig ist.

In einer besonders vorteilhaften Ausgestaltung der Erfindung ist der Sensor ein supraleitendes Quanteninterferometer (SQUID). SQUIDs sind in ihrer Empfindlichkeit von etwa 1 fT/Hz$^{1/2}$ in Kombination mit vielen anderen Eigenschaften für viele praktische Anwendungen immer noch unübertroffen. Sie benötigen eine Kühlung, um den supraleitenden Zustand zu halten, doch ist die dafür nötige Technik bereits vorhanden, da der Flusstransformator erfindungsgemäß bereits supraleitende Komponenten enthält. Das SQUID kann eine supraleitende Schleife umfassen, die durch mindestens einen (rf-SQUID) oder zwei (dc-SQUID) Josephson-Kontakte unterbrochen ist. Es kann auch zwei supraleitende Schleifen umfassen, die durch insgesamt drei (3JJ-SQUID) Josephson-Kontakte unterbrochen sind. Außer SQUIDs kann man auch andere Magnetfeldsensoren, wie zum Beispiel GMR, CMR, Hall- oder Fluxgate-Magnetfeldsensoren für die Messung von durch den Flusstransformator verstärkten und gefilterten Magnetfeldern oder Magnetfeldgradienten einsetzen. Diese Sensoren sind weniger empfindlich als SQUIDs, aber sie eignen sich besonders für Anwendungen, in denen nur die Leiterschleife und die Magnetfeldquelle gekühlt werden können, nicht jedoch der Sensor.

In einer besonders vorteilhaften Ausgestaltung der Erfindung ist die Magnetfeldquelle Teil des Sensors. Beispielsweise kann eine supraleitende Spule mit einer Windung als Magnetfeldquelle durch einen oder mehrere Josephson-Kontakte unterbrochen sein. Die Spule mit den Josephson-Kontakten bildet dann ein SQUID, das den magnetischen Fluss misst, den der aus der Leiterschleife eingespeiste Strom beim Durchgang durch die gleiche Spule erzeugt ("direkt gekoppeltes SQUID"). Eine solche Anordnung ist möglich, da sich auf Grund des Superpositionsprinzips der aus der Leiterschleife eingespeiste Strom und das an den Josephson-Kontakten erzeugte Signal in der Spule störungsfrei überlagern.

In einer besonders vorteilhaften Ausgestaltung der Erfindung sind die Leiterschleife und die Magnetfeldquelle derart verschaltet, dass eine über die von der Leiterschleife eingeschlossene Fläche räumlich homogene Änderung des zu messenden Feldes den Strom durch die Magnetfeldquelle ungeändert lässt. Dann ist das Messinstrument ein Gradiometer, das nur den räumlichen Gradienten des magnetischen Feldes am Ort der Leiterschleife misst.

In einer besonders vorteilhaften Ausgestaltung der Erfindung enthält der Verbraucherbereich ein Material, das keinen Phasenübergang zum supraleitenden Zustand besitzt. Ein solches Material bleibt beim Abkühlen des Basismaterials unter dessen Sprungtemperatur normalleitend beziehungsweise isolierend und ist dann die Quelle des elektrischen Widerstands. Beispielsweise kann der Verbraucherbereich eine Tunnelbarriere des Tunnelkontaktes zwischen supraleitenden Elektroden umfassen. Er enthält dann vorteilhaft ein sehr dünnes Isolator-Material aus der Gruppe $AlO_x$, MgO, AlN oder MgO-NiO-MgO, wenn das Basismaterial und Material der supraleitenden Elektroden ein Niedertemperatursupraleiter wie beispielsweise Nb, NbN, $Nb_3Sn$, NbTa, NbTi, oder $MgB_2$ ist. Für Hochtemperatursupraleiter mit einer Sprungtemperatur von über 50 K als Basismaterial ist hier insbesondere eine Verbindung gemäß der Formel $ZBa_2Cu_3O_{7-x}$ geeignet, worin Z ein Element aus der Gruppe (Y, Nd, Gd, Ho, Sm, Tm, Tb, Dy, Yb, Er oder Eu) ist. Beispielsweise hat $YBa_2Cu_3O_{7-x}$ eine Sprungtemperatur von etwa 93 K. Die Materialien $PrBa_2Cu_3O_{7-x}$ oder $SrTiO_3$ sind besonders geeignet für die Tunnelbarrieren, wenn $YBa_2Cu_3O_{7-x}$ das Basismaterial und Material der supraleitenden Elektroden ist. Die Tunnelkontakte sind überwiegend Dünnschicht-Strukturen, um die Isolator-Schichten mit typischen Dicken von weniger als 100 nm kontrollierbar herzustellen.

Der Verbraucherbereich kann aber auch normalleitende Metalle, wie beispielsweise Silber, Gold, Platin oder ihre Legierungen, enthalten. Dann kann der normalleitende Widerstand dieser Metalle ausgenutzt werden, ohne dass es notwendig ist, einen komplizierten Tunnelkontakt herzustellen. Wenn das Basismaterial ein Hochtemperatursupraleiter ist, der eine Verbindung gemäß der Formel $ZBa_2Cu_3O_{7-x}$ enthält, können speziell Silber, Gold, Platin oder ihre Legierungen mit besonders geringen Kontaktwiderständen an Elektroden aus diesem Basismaterial angekoppelt werden. Ist das Basismaterial ein Tieftemperatursupraleiter, wie Nb, NbN, $Nb_3Sn$, NbTa, NbTi, oder $MgB_2$, ist es sogar noch einfacher, einen vernachlässigbaren Kontaktwiderstand zu Silber, Gold, Platin oder deren Legierungen zu realisieren. Außerdem ist es bei Basismaterialien aus Tieftemperatursupraleitern möglich, einen Schichtstapel herzustellen, in dem das normalleitende Metall (zum Beispiel, Silber, Gold, Platin oder ihre Legierungen) zwischen der unteren und oberen supraleitenden Elektrode plaziert ist. Außerdem ist es im Fall von Tieftemperatursupraleitern als Basismaterial sogar möglich, einen niederohmigen Widerstand auf der Basis von normalleitenden Folien mit auf die beiden Seiten dieser Folien aufgetragenen Tieftemperatursupraleiter-Schichten relativ einfach herzustellen.

In einer besonders vorteilhaften Ausgestaltung der Erfindung umfasst der Verbraucherbereich eine koplanare Struktur aus voneinander beabstandeten Elektroden auf einem Substrat, wobei diese Elektroden insbesondere das Basismaterial der Leiterschleife enthalten können. Dabei können die Elektroden insbesondere als Dünnschichten ausgebildet sein. Die Elektroden können schleifenförmig ausgebildet sein. Die unterhalb ihrer Sprungtemperatur supraleitenden Elektroden sind durch eine normalleitende Widerstandsschicht verbunden. Strukturen dieser Art produzieren nur ein geringes magnetisches Rauschen und lassen sich mittels optischer Lithographie oder Elektronenstrahl-Lithographie in einer Vielzahl von Formen herstellen. Der Widerstand dieser Strukturen ist die Summe des Widerstandes der normalleitenden Schicht zwischen den supraleitenden Elektroden und zweier Kontaktwiderstände zwischen der normalleitenden Schicht und den supraleitenden Elektroden. Die Kontaktwiderstände sollen möglichst gering sein, so dass sie im Idealfall vernachlässigt werden können. Der Abstand der Elektroden zueinander soll einerseits kurz sein, um den Widerstand der normalleitenden Schicht zu minimieren. Er muss aber lang genug sein, dass supraleitende Kurzschlüsse noch vermieden werden. Es ist auch wünschenswert, eine möglichst lange Strecke zu realisieren, auf der die Elektroden einander beabstandet gegenüberstehen. Je länger diese Strecke zwischen den Elektroden ist, desto geringer ist der Widerstand der Struktur. Einen besonders geringen Widerstand bei gleichzeitig relativ geringem magnetischem Rauschen erhält man in einer vorteilhaften Ausgestaltung der Erfindung, in der die Elektroden mäanderformig ausgebildet sind. Einen noch geringeren Widerstand erhält man um den Preis eines höheren magnetischen Rauschens mit einer interdigitierenden Struktur. Darin sind immer je ein "Finger" der einen Elektrode und ein "Finger" der anderen Elektrode benachbart und voneinander beabstandet angeordnet.

Ist etwa das Basismaterial der Leiterschleife ein Hochtemperatursupraleiter, der eine Verbindung gemäß der Formel $ZBa_2Cu_3O_{7-x}$ enthält, so wachsen epitaktische Schichten aus dem gleichen Material am besten auf Substraten aus MgO oder $SrTiO_3$. Beide Materialien sind Isolatoren und beeinflussen die Transport-Eigenschaften der Dünnschicht-Strukturen nicht. Wegen ihres geringeren spezifischen Widerstandes und einem kleinen Kontaktwiderstand zu $ZBa_2Cu_3O_{7-x}$ kommen als Widerstandsschicht-Materialien vorteilhaft Silber, Gold, Platin oder ihre Legierungen zum Einsatz.

In einer alternativen vorteilhaften Ausgestaltung der Erfindung umfasst der Verbraucherbereich einen Schichtstapel aus Elektroden mit einer zwischen den Elektroden angeordneten Widerstandsschicht. Dabei sind die Elektroden unterhalb ihrer Sprungtemperatur supraleitend. Sie sind durch die Widerstandsschicht elektrisch verbunden. Diese Ausgestaltung ist insbesondere dann sinnvoll, wenn die Elektroden aus dem Basismaterial bestehen und dieses ein Tieftemperatursupraleiter wie Niob ist. Bestehen die Elektroden aus einem Hochtemperatursupraleiter, ist es möglich, solche Schichtstapel in der so genannten flip-chip Technologie zu realisieren: Man kann beide supraleitende Elektroden auf zwei verschiedenen Substraten epitaktisch herzustellen, fotolithografisch strukturieren und durch eine zwischen den Substraten angeordnete normalleitende Schicht elektrisch miteinander verbinden. Die normalleitende Schicht kann dabei insbesondere aus Schichten gebildet werden, die vor dem Zusammenfügen der Substrate auf einem der Substrate oder auch auf beiden Substraten vorhanden sind.

Die Magnetfeldquelle und der Verbraucherbereich können als dünne Schichten auf dem gleichen Substrat strukturiert sein ("integriert") oder alternativ auf separaten Substraten strukturiert sein, die mit ihren strukturierten Oberflächen aneinandergefügt sind ("flip-chip"-Technologie). Auch können die Leiterschleife und die Magnetfeldquelle als dünne Schichten auf dem gleichen Substrat strukturiert sein ("integriert") oder alternativ auf separaten Substraten strukturiert sein, die mit ihren strukturierten Oberflächen aneinandergefügt sind ("flip-chip"-Technologie). Der Sensor und die Magnetfeldquelle können auf dem gleichen Substrat strukturiert sein ("integriert") oder alternativ auf separaten Substraten strukturiert sein, die mit ihren strukturierten Oberflächen aneinandergefügt sind ("flip-chip"-Technologie). Die Integration von Magnetfeldquelle und Sensor kann auch so weit gehen, dass die Magnetfeldquelle ein Teil des Sensors ist. In der bevorzugten Ausgestaltung, dass der Sensor ein SQUID ist, kann insbesondere die von einem oder mehreren Josephson-Kontakten unterbrochene Leiterschleife des SQUID zugleich als Magnetfeldquelle dienen, die die von der Leiterschleife begrenzte Fläche mit dem magnetischen Hilfsfeld beaufschlagt. Dieses Prinzip ist am besten geeignet, wenn das Basismaterial ein Hochtemperatursupraleiter ist. Wenn das Basismaterial dagegen ein Tieftemperatursupraleiter ist, werden bessere Ergebnisse erzielt, wenn die Magnetfeldquelle elektrisch vom SQUID isoliert und somit nur induktiv an das SQUID angekoppelt ist.

Alle diese Ausgestaltungen weisen den Vorteil auf, dass sie sich mit den in der Massenfertigung gängigen fotolithografischen Strukturierungstechniken herstellen lassen.

In einer weiteren vorteilhaften Ausgestaltung der Erfindung befinden sich der Sensor und die Magnetfeldquelle innerhalb einer magnetischen Abschirmung. Dann kann die Leiterschleife nach wie vor außerhalb der Abschirmung verbleiben. Ist sie einem langsam veränderlichen äußeren Störfeld ausgesetzt oder wird sie durch ein solches Feld bewegt, wird die dadurch in sie eingebrachte elektrische Energie durch den Verbraucherbereich dissipiert.

Das erfindungsgemäße Messinstrument macht sich einen maßgeschneiderten Widerstandswert des Verbraucherbereichs nahe Null zunutze. Wie bereits oben ausgeführt, können solche rauscharmen Widerstände nicht nur für Flusstransformatoren und Sensoren, sondern auch für mehrere andere Strukturen der supraleitenden Elektronik, zum Beispiel RSFQ oder Quantencomputer, verwendet werden. Daher bezieht sich die Erfindung allgemein auch auf ein elektrisches Widerstandselement mit einem von Null verschiedenen Widerstandswert von $10^{-4}\,\Omega$ oder weniger, bevorzugt von $10^{-6}\,\Omega$ oder weniger. Dieses Widerstandselement kann zwei besonders vorteilhafte Ausführungen haben:

- eine koplanare Struktur aus voneinander beabstandeten Elektroden, die durch eine normalleitende Widerstandschicht elektrisch verbunden sind und insbesondere auf einem Substrat angeordnet sein können, wobei die Elektroden insbesondere mäanderförmig ausgestaltet sein können und/oder die Struktur interdigitierend ausgestaltet sein kann, und/oder
- einen Schichtstapel aus Elektroden, zwischen denen eine normalleitende Widerstandsschicht angeordnet ist.

Dabei weist das Material der Elektroden jeweils einen Phasenübergang zum supraleitenden Zustand auf. Die Elektroden können insbesondere fotolithographisch strukturiert sein.

Die normalleitende Widerstandsschicht kann insbesondere aus einem normalleitenden Metall und besonders bevorzugt aus Gold, Silber, Platin oder einer diese Elemente enthaltenden Legierung bestehen. Der Schichtstapel kann auch eine dünne Folie aus einem normalleitenden Metall umfassen, welche beidseitig jeweils mit einem Material beschichtet ist, das einen Phasenübergang zum supraleitenden Zustand aufweist.

Ausgehend von diesen Konstruktionsansätzen und den weiteren Randbedingungen für den Ort in der supraleitenden Schaltung, wo das Widerstandselement zum Einsatz kommen soll, kann der Fachmann mit den ihm geläufigen Methoden der klassischen Elektrodynamik eine konkrete Ausgestaltung mit einem vorgegebenen Widerstandswert realisieren.

Da das Widerstandselement als Schlüsselelement in dem erfindungsgemäßen Messinstrument verwendbar ist, welches wiederum die erste Realisierung einer Vorrichtung zur Durchführung des im Folgenden dargestellten erfindungsgemäßen Verfahrens ist, erstreckt sich der im Zusammenhang mit dem Messinstrument gegebene Offenbarungsumfang in Bezug auf das Widerstandselement ausdrücklich auch auf das Widerstandselement als solches.

Die Erfindung bezieht sich auch auf ein Messsystem für biomagnetische Messungen, für geomagnetische Messungen, für zerstörungsfreie Materialprüfung und/oder für Materialforschung, das ein erfindungsgemäßes Messinstrument oder ein erfindungsgemäßes elektrisches Widerstandselement enthält. In diesen Anwendungen kommen die jeweiligen erfindungsgemäßen Vorteile in besonderem Maße der Empfindlichkeit, der spektralen Bandbreite und dem Dynamikbereich des Messsystems zu Gute.

<u>Spezieller Beschreibungsteil</u>

Nachfolgend wird der Gegenstand der Erfindung anhand von Figuren näher erläutert, ohne dass der Gegenstand der Erfindung dadurch beschränkt wird. Es ist gezeigt:

Figur 1: Ausführungsbeispiel des erfindungsgemäßen Messinstruments.

Figur 2: Mögliche Ausgestaltungen eines erfindungsgemäßen Widerstandselements ("Verbraucherbereich"): Schichtstapel mit Widerstandsschicht oder Tunnelbarriere als mittlere Schicht (Teilbild a), koplanare Struktur zweier mäanderformig ausgebildeter Elektroden (Teilbild b) und interdigitierende Struktur zweier Elektroden (Teilbild c).

Figur 3: Weiteres Ausführungsbeispiel des erfindungsgemäßen Messinstruments, das in "flip-chip" Technologie herstellbar ist (Teilbild a); direkt gekoppeltes SQUID als Sensor und Magnetfeldquelle in einem Bauelement (Teilbild b).

Figur 4: Ausführungsbeispiele einer Verschaltung von Pick-up-Spule und Einkoppelspule, die jeweils als Gradiometer wirken: Struktur mit Einkoppelspule als Verbindung in der Mitte (Teilbild a und Teilbild b) und zwei sich kreuzende Teilschleifen (Teilbild c) oder drei sich kreuzende Teilschleifen (Teilbild d).

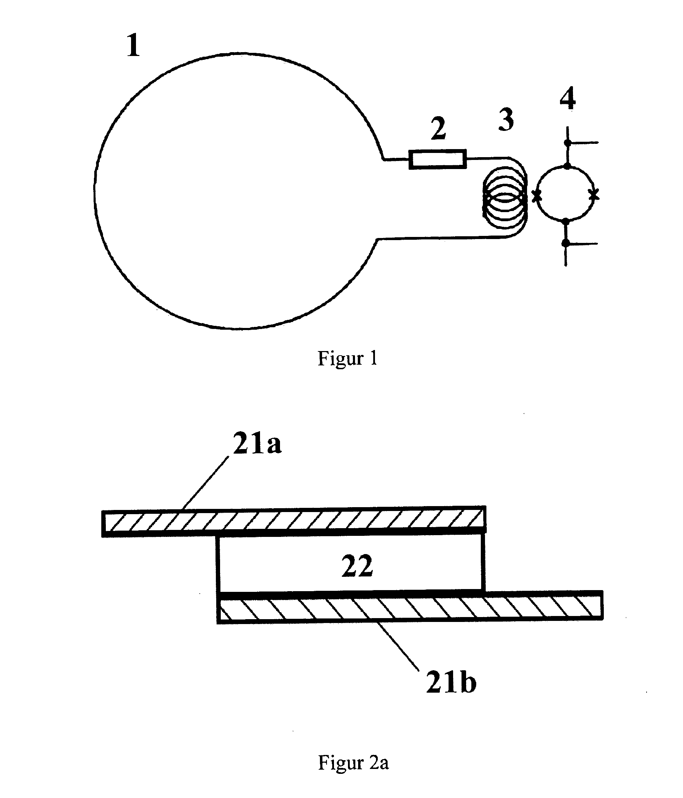

In Figur 1 ist ein Ausführungsbeispiel des erfindungsgemäßen Messinstruments skizziert. Der Flusstransformator ist ein Stromkreis, der aus einer Serienschaltung einer supraleitenden Leiterschleife als Pick-up-Spule 1, eines niederohmigen Widerstands 2 als Verbraucherbereich und einer supraleitenden Spule 3 als Einkoppelspule besteht. In dieser Ausführungsform bewirkt jede Änderung des magnetischen Flusses durch die Pick-up-Spule 1 einen Strom durch die Spule 3 und liefert somit einen Beitrag zum von der Spule 3 erzeugten magnetischen Hilfsfeld. Das Hilfsfeld wird mit einem supraleitenden Quanteninterferometer (SQUID) 4 gemessen.

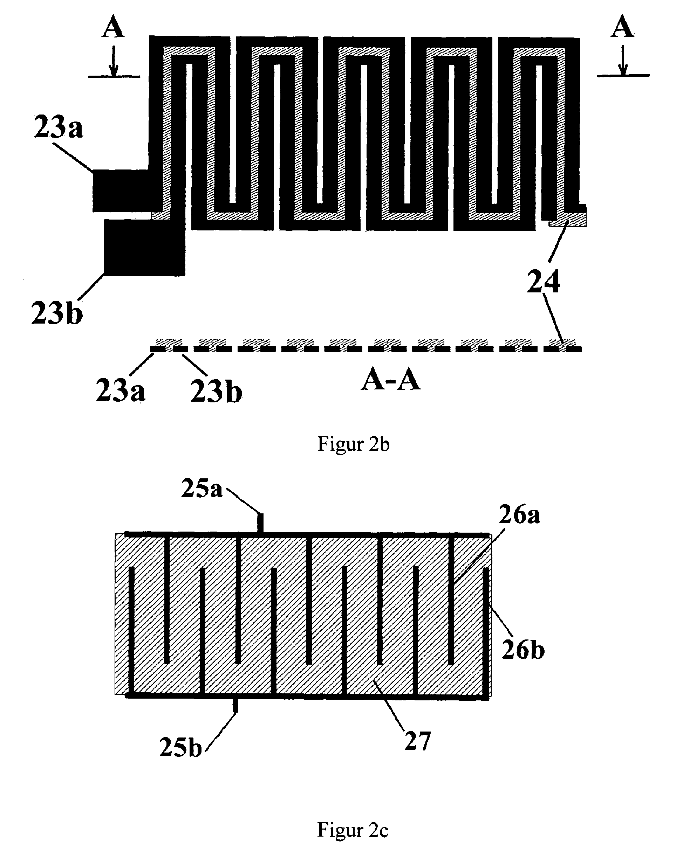

Figur 2 zeigt drei mögliche Ausgestaltungen des erfindungsgemäßen elektrischen Widerstandselements, die als Verbraucherbereich 2 verwendbar sind.

Figur 2a zeigt einen Querschnitt durch ein Ausführungsbeispiel für einen Schichtstapel aus Elektroden 21 a und 21b mit einer zwischen den Elektroden angeordneten Widerstandsschicht 22. Die Elektroden 21a und 21b bestehen aus einem tieftemperatursupraleitenden Basismaterial (Nb, NbN, $Nb_3Sn$, NbTa, NbTi, oder $MgB_2$) oder einem hochtemperatursupraleitenden Basismaterial (zum Beispiel aus einem supraleitenden Material gemäß der Formel $ZBa_2Cu_3O_{7-x}$, wobei Z insbesondere Yttrium sein kann). Als Widerstandsschicht 22 kann ein Isolator (nur im Fall von Tunnelbarrieren) oder ein normalleitendes Material vorgesehen sein.

Figur 2b zeigt ein Ausführungsbeispiel für eine koplanare Struktur supraleitender Elektroden 23a und 23b in nicht maßstabsgetreu gezeichneter Schemazeichnung in Aufsicht. Die Elektroden bestehen aus einem tieftemperatursupraleitenden Basismaterial (Nb, NbN, $Nb_3Sn$, NbTa, NbTi, oder $MgB_2$) oder hochtemperatursupraleitenden Basismaterial (zum Beispiel aus einem supraleitenden Material gemäß der Formel $ZBa_2Cu_3O_{7-x}$, wobei Z insbesondere Yttrium sein kann) und sind auf einem in Figur 2b nicht eingezeichneten isolierenden Substrat aus MgO oder $SrTiO_3$ aufgebracht. Die Elektrode 23a und die Elektrode 23b sind zueinander benachbart angeordnet mit einem Abstand von, zum Beispiel, 50 $\mu$m. Somit sind die Elektroden 23a und 23b beabstandet benachbart angeordnet und durch ein normalleitendes Material 24 miteinander elektrisch verbunden. Der mäanderförmige Weg entlang des normalleitenden Materials 24 hat eine beträchtliche Länge. Dieser Weg ist deutlich länger als die Kantenlänge der gesamten Struktur von etwa 1 cm. Das normalleitende Material 24 kann beispielsweise als lateral strukturierte Widerstandsschicht auf die Elektroden 23a und 23b aufgebracht sein, wie die Schnittzeichnung im unteren Teil von Figur 2b verdeutlicht.

Der Gesamtwiderstand des so ausgeführten Widerstandselements ergibt sich zu

$$R = \rho \cdot \frac{l}{d \cdot w}.$$

Hierin sind p der spezifische Widerstand des Materials (zum Beispiel Silber), aus dem die normalleitende Widerstandsschicht besteht, und d die Dicke der Widerstandsschicht (typisch etwa 1 $\mu$m). $l$ ist der Abstand zwischen den beiden supraleitenden Elektroden 23a und 23b (typischerweise 50 $\mu$m), und w ist die effektive Breite (ca. 100 cm) der normalleitenden Widerstandsschicht 24 ("Verbraucherbereich") gemessen entlang der mäanderförmigen normalleitenden Verbindung zwischen den supraleitenden Elektroden 23a und 23b. Das Material Silber der Widerstandsschicht hat einen spezifischen Widerstand $\rho$ von etwa 1 $\mu\Omega$ cm bei niedrigen Temperaturen, so dass sich für die in Figur 2b gezeigte Anordnung insgesamt ein Widerstand R von 5 x $10^{-7}$ $\Omega$ ergibt, sofern die Elektroden 23a und 23b sich im supraleitenden Zustand befinden.

Figur 2c zeigt ein Ausführungsbeispiel für eine interdigitierende Struktur supraleitender Elektroden 25a und 25b in nicht maßstabsgetreu gezeichneter Schemazeichnung in Aufsicht. Die Elektroden bestehen aus einem tieftemperatursupraleitenden Basismaterial (Nb, NbN, Nb$_3$Sn, NbTa, NbTi, oder MgB$_2$) oder hochtemperatursupraleitenden Basismaterial (zum Beispiel ein Material gemäß der Formel ZBa$_2$Cu$_3$O$_{7-x}$, wobei Z insbesondere Yttrium sein kann) und sind auf einem in Figur 2c nicht eingezeichneten isolierenden Substrat aus MgO oder SrTiO$_3$ aufgebracht. Je ein "Finger" 26a der Elektrode 25a und ein "Finger" 26b der Elektrode 25b sind zueinander benachbart angeordnet mit einem Abstand von, zum Beispiel, 50 $\mu$m. Somit sind die Elektroden 25a und 25b beabstandet benachbart angeordnet und durch ein normalleitendes Material 27 miteinander elektrisch verbunden. Der mäanderförmige Weg im Zwischenraum der beiden Fingerelektroden 26a und 26b hat eine beträchtliche Länge. Dieser Weg ist deutlich länger als die typische Kantenlänge der gesamten Struktur von etwa 1 cm. Entlang dieses Weges wird die mit Widerstand behaftete elektrische Verbindung zwischen den Elektroden 25a und 25b durch eine Widerstandsschicht vermittelt, die auf die interdigitierende Struktur aufgebracht ist. Es ist zu erwarten, dass bei gleicher Kantenlänge der Struktur die Anordnung nach Figur 2c einen kleineren Widerstand, aber wesentlich größeres Rauschen aufweist als die Struktur nach Figur 2b.

Figur 3a zeigt ein weiteres Ausführungsbeispiel des erfindungsgemäßen Messinstruments in nicht maßstabsgetreu gezeichneter Schemazeichnung in Aufsicht. Auf einem ersten Substrat 5a ist die supraleitende Pick-up-Spule 1 strukturiert, die über einen niederohmigen Widerstand 2 die hier als spiralförmige supraleitende Spule ausgestaltete und auf dem gleichen Substrat 5a strukturierte Einkoppelspule 3 speist. Diese Einkoppelspule 3 ist innerhalb des von der Pick-up-Spule 1 umschlossenen Bereichs angeordnet. Der Sensor 4 ist hier als SQUID ausgestaltet und umfasst einen Supraleiter 41, der durch zwei Josephson-Kontakte 42a und 42b unterbrochen und durch zwei metallische Kontakte 43a und 43b mit der in Figur 3 nicht eingezeichneten Auswerteeinheit kontaktiert ist. Der Sensor 4 ist auf einem zweiten Substrat 5b strukturiert. Die beiden Substrate 5a und 5b werden zu dem erfindungsgemäßen Messinstrument vereinigt, indem sie mit ihren strukturierten Oberflächen aneinandergefügt werden. Dazu kann beispielsweise das Substrat 5a über das Substrat 5b geklappt werden ("flip-chip" Technik). Die Spule 3 liegt dann innerhalb des Supraleiters 41, so dass das von ihr erzeugte magnetische Hilfsfeld vom SQUID 4 registriert werden kann.

Figur 3b zeigt ein Ausführungsbeispiel des erfindungsgemäßen Messinstruments, in dem die Magnetfeldquelle 3 Teil des hier als SQUID ausgeführten Sensors 4 ist. Die Magnetfeldquelle 3, die hier die Einkoppelspule ist, ist zugleich auch die Spule mit einer Windung, die durch zwei Josephson-Kontakte unterbrochen ist und so das SQUID 4 bildet. Der Strom, der aus der Pick-up-Spule 1 in die Einkoppelspule 3 eingespeist wird, fließt entlang der Grenze des Bereiches, in dem das SQUID sensitiv ist, ohne jedoch durch die Josephson-Kontakte zu fließen (durch die Pfeile in Figur 3b verdeutlicht). Er erzeugt somit das magnetische Hilfsfeld direkt im SQUID, ohne zugleich die Messung dieses Hilfsfeldes zu stören.

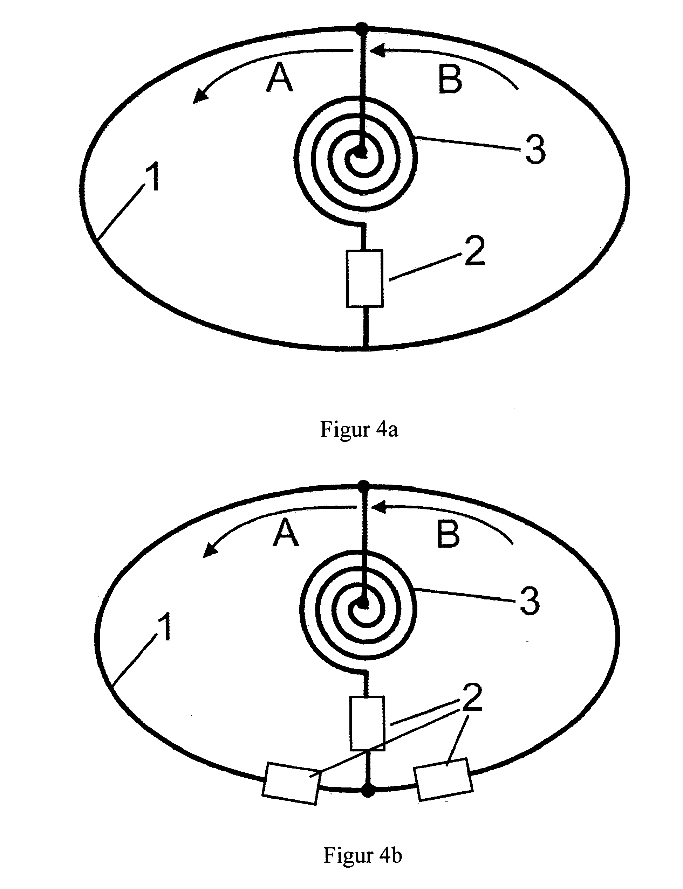

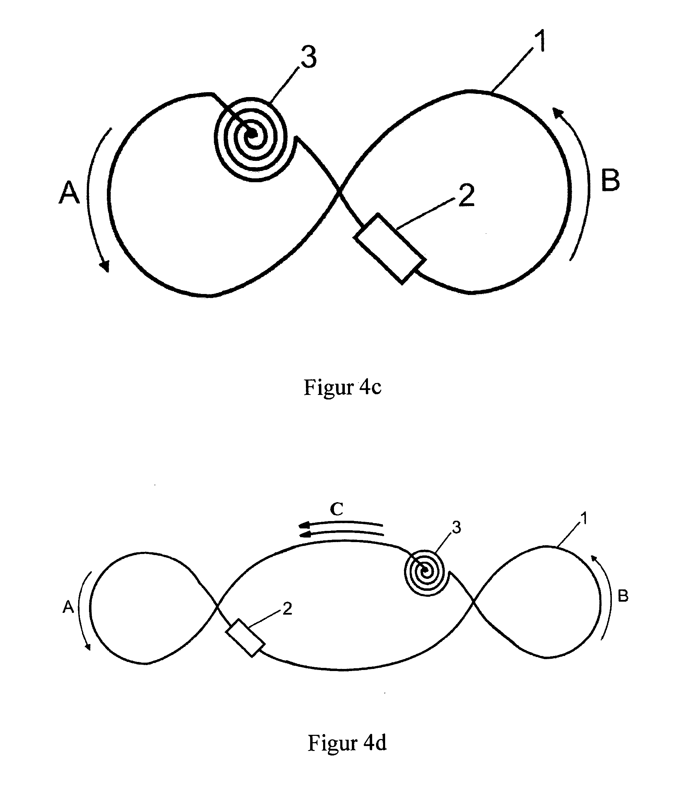

Figur 4 zeigt vier Ausführungsbeispiele einer Verschaltung von Einkoppelspule 3 und supraleitender Pick-up-Spule 1, in denen eine über die Pick-up-Spule 1 homogene Änderung des zu messenden Flusses den Strom durch die supraleitende Einkoppelspule 3 ungeändert lässt. Alle Teilbilder a bis d sind jeweils nicht maßstabsgetreu gezeichnete Schemazeichnungen in Aufsicht.

In Figur 4a ist die Pick-up-Spule 1 ellipsenförmig ausgestaltet. Auf ihrer kleinen Halbachse ist eine Reihenschaltung aus spiralenförmiger Spule 3 und niederohmigem Widerstand 2 angeordnet. Eine über die Pick-up-Spule 1 räumlich homogene Änderung des zu messenden Feldes führt dazu, dass zwei betragsmäßig gleiche, entgegengesetzte Ströme A und B in der Pick-up-Spule 1 induziert werden, die sich gegenseitig aufheben und daher nicht zum Strom durch die Einkoppelspule 3 beitragen. In Figur 4b sind zusätzlich zwei weitere Widerstände ("Verbraucherbereiche") in die Pick-up-Spule integriert, mit denen die Ströme A und B noch in der Pick-up-Spule hochpassgefiltert und dissipiert werden.

Das gleiche Prinzip ist auch in Figur 4c realisiert; wo die Pick-up-Spule 1 aus zwei sich kreuzenden flächengleichen Teilschleifen besteht und die Form des mathematischen Unendlich-Zeichens hat.

Die in den Figuren 4a bis 4c dargestellten Anordnungen sind Gradiometer erster Ordnung. Eine über die Pick-up-Spule 1 räumlich homogene Änderung zu messenden Feldes führt jeweils zu keinem Strom durch die Einkoppelspule 3. Nur eine über die Pick-up-Spule 1 räumlich inhomogene Änderung des zu messenden Flusses führt zu betragsmäßig unterschiedlichen Strömen A und B und damit zu einem Differenzstrom durch die Einkoppelspule 3, der ein magnetisches Hilfsfeld erzeugt. Dieses Hilfsfeld kann durch den in Figur 4 nicht eingezeichneten Sensor registriert werden.

Figur 4d zeigt ein Gradiometer zweiter Ordnung. Es besteht aus drei Teilschleifen, in denen ein zeitvariables Magnetfeld oder ein zeitvariabler Magnetfeldgradient jeweils einen Strom A, B bzw. C induziert. Die mittlere Teilschleife hat dabei den gleichen Flächeninhalt wie die beiden anderen Teilschleifen zusammen. Die drei Teilschleifen kreuzen sich an zwei Stellen. Sowohl bei einer räumlich homogenen Änderung des zu messenden Feldes als auch bei einer Änderung in Form eines Gradienten erster Ordnung kompensieren sich die drei Ströme A, B und C, so dass kein Strom durch die Einkoppelspule 3 fließt. Nur bei einem Gradienten zweiter Ordnung kompensieren sich die Ströme nicht. Die Einkoppelspule 3 wird dann von einem Strom durchflossen und erzeugt ein vom Sensor detektierbares Hilfsfeld.

Das gleiche Prinzip ist auch auf Gradiometer höherer Ordnung anwendbar.

Allen vier Anordnungen ist gemein, dass die Einkoppelspule 3 zumindest teilweise innerhalb des von der Pick-up-Spule 1 umschlossenen Bereichs angeordnet ist. Es ist hier sogar der Idealfall realisiert, dass abgesehen von der Pick-up-Spule 1 selbst keine zusätzlichen Zuleitungen für die Einkoppelspule 3 erforderlich sind.

**Patentansprüche**

1. Elektrisches Widerstandselement mit einem von Null verschiedenen Widerstandswert von $10^{-4}$ $\Omega$ oder weniger, bevorzugt von $10^{-6}$ $\Omega$ oder weniger, welches eine koplanare Struktur aus voneinander beabstandeten, insbesondere mäanderförmig ausgebildeten, Elektroden (23a, 23b), die durch eine Widerstandsschicht (24) aus einem normalleitenden Metall elektrisch verbunden sind, umfasst, wobei das Material der Elektroden (23a, 23b) einen Phasenübergang zum supraleitenden Zustand besitzt, **dadurch gekennzeichnet, dass** die Struktur interdigitierend ausgestaltet ist und dass das Material der Elektroden ein Hochtemperatursupraleiter mit einer Sprungtemperatur von über 50 K ist.

2. Messinstrument für zeitveränderliche magnetische Felder oder Feldgradienten mit

   • einem Flusstransformator, wobei dieser Flusstransformator eine Leiterschleife (1) umfassend ein Basismaterial, das einen Phasenübergang zum supraleitenden Zustand besitzt, zur Umwandlung eines zeitveränderlichen magnetischen Flusses oder Flussgradienten in einen elektrischen Strom sowie eine aus dieser Leiterschleife gespeiste Magnetfeldquelle (3) zur Umwandlung des elektrischen Stroms in ein magnetisches Hilfsfeld aufweist, wobei das Material der Magnetfeldquelle insbesondere einen Phasenübergang zum supraleitenden Zustand besitzen kann, und

   • einem Sensor (4), welcher insbesondere ein supraleitendes Quanteninterferometer, SQUID, sein kann, für das magnetische Hilfsfeld, wobei der Flusstransformator auch dann, wenn sich das Basismaterial im supraleitenden Zustand befindet, mindestens einen resistiven Verbraucherbereich (2) zur Dissipation der elektrischen Energie in dem Stromkreis, der die Leiterschleife (1) und die Magnetfeldquelle (3) umfasst, aufweist, wobei die Leiterschleife (1) und die Magnetfeldquelle (3) in einer Ebene angeordnet sind und wobei die Magnetfeldquelle (3) insbesondere Teil des Sensors (4) sein kann,
   **dadurch gekennzeichnet, dass**

   • mindestens ein elektrisches Widerstandselement nach Anspruch 1 oder ein Tunnelkontakt mit einem Isolator-Material, das keinen Phasenübergang zum supraleitenden Zustand besitzt, als Verbraucherbereich (2) vorgesehen ist, und/oder
   • die Leiterschleife (1) und die Magnetfeldquelle (3) auf separaten Substraten strukturiert sind, die mit ihren strukturierten Oberflächen aneinandergefügt und elektrisch verbunden sind, wobei auf einem Substrat oder auf beiden Substraten eine normalleitende Schicht angeordnet ist, die den Verbraucherbereich (2) bildet, wobei das Basismaterial ein Hochtemperatursupraleiter mit einer Sprungtemperatur von über 50 K ist.

3. Messinstrument nach vorhergehendem Anspruch, **dadurch gekennzeichnet, dass** der Verbraucherbereich (2) ein normalleitendes Metall aus der Gruppe Ag, Au, Pt oder ihrer Legierungen aufweist.

4. Messinstrument nach einem der vorhergehenden Ansprüche, **dadurch gekennzeichnet, dass** der Tunnelkontakt (22) zwischen den den Schichtstapel bildenden Elektroden (21a, 21b) ein Isolator-Material aus der Gruppe $AlO_x$, MgO, AlN, MgO-NiO-MgO, $PrBa_2Cu_3O_{7-x}$, oder $SrTiO_3$, aufweist, wobei die Leiterschleife (1) und/oder die Magnetfeldquelle (3) insbesondere als Dünnschichten mit einer Schichtdicke von 1 $\mu$m oder weniger ausgebildet sein können.

5. Messinstrument nach einem der vorhergehenden Ansprüche, **dadurch gekennzeichnet, dass** die Leiterschleife (1), "Pick-up-Spule", und/oder die Magnetfeldquelle (3), "Einkoppelspule", Spulen mit je mindestens einer Windung sind, wobei bevorzugt

   • die Pick-up-Spule (1) einen Durchmesser von 1 cm oder mehr, bevorzugt von 3 cm oder mehr und besonders bevorzugt von 5 cm oder mehr aufweisen kann und/oder

• die Einkoppelspule (3) einen Durchmesser von 3 mm oder weniger aufweisen kann.

6. Messinstrument nach vorhergehendem Anspruch, **dadurch gekennzeichnet, dass** das Verhältnis der Durchmesser von Einkoppelspule (3) und Pick-up-Spule (1) höchstens 0,1 beträgt.

7. Messinstrument nach einem der vorhergehenden 2 Ansprüche, **dadurch gekennzeichnet, dass** die Einkoppelspule (3) zwischen 80 % und 120 % der Induktivität der Pick-up-Spule (1) aufweist, wobei insbesondere die Pick-up Spule (1) und die Einkoppelspule (3) gleiche Induktivitäten aufweisen können.

8. Messinstrument nach einem der vorhergehenden 3 Ansprüche, **dadurch gekennzeichnet, dass** das Verhältnis der Windungszahlen von Einkoppelspule (3) und Pick-up-Spule (1) mindestens so groß ist wie die Quadratwurzel des Verhältnisses der Durchmesser von Einkoppelspule (3) und Pick-Up-Spule (1).

9. Messinstrument nach einem der vorhergehenden Ansprüche, **dadurch gekennzeichnet, dass** die Magnetfeldquelle (3) zumindest teilweise innerhalb des von der Leiterschleife (1) umschlossenen Bereichs angeordnet ist.

10. Messinstrument nach einem der vorhergehenden Ansprüche, **dadurch gekennzeichnet, dass** der Verbraucherbereich (2) einen elektrischen Widerstand zwischen $10^{-11}$ $\Omega$ und $10^{-5}$ $\Omega$, insbesondere zwischen $10^{-11}$ $\Omega$ und $10^{-6}$ $\Omega$, aufweist.

11. Messinstrument nach einem der vorhergehenden Ansprüche, **dadurch gekennzeichnet, dass** der Flusstransformator eine Induktivität zwischen 1 nH und 1 mH, insbesondere zwischen 10 nH und 100 $\mu$H, aufweist.

12. Messinstrument nach einem der vorhergehenden Ansprüche, **dadurch gekennzeichnet, dass** ein im Flusstransformator zirkulierender elektrischer Strom mindestens dann, wenn sich das Basismaterial im supraleitenden Zustand befindet, eine Relaxationszeit $\tau$ zwischen 1 ms und $10^6$ s, insbesondere zwischen 3 ms und 300 s, hat.

13. Messinstrument nach einem der vorhergehenden Ansprüche, **dadurch gekennzeichnet, dass** die Übertragungsfunktion des Flusstransformators, die die Umwandlung des zu messenden Feldes oder Feldgradienten in das Hilfsfeld beschreibt, ein Hochpass ist, welcher insbesondere eine Abschneidefrequenz $f_0$ zwischen 1 $\mu$Hz und 1 kHz, insbesondere zwischen 3 mHz und 300 Hz, aufweisen kann, wobei bevorzugt die Übertragungsfunktion des Flusstransformators, die die Umwandlung des zu messenden Flusses in das Hilfsfeld beschreibt, für Frequenzen zwischen der Abschneidefrequenz $f_0$ des Hochpasses und 1 MHz durchlässig sein kann.

14. Messinstrument nach einem der vorhergehenden Ansprüche, **dadurch gekennzeichnet, dass** Leiterschleife (1) und Magnetfeldquelle (3) derart verschaltet sind, dass eine über die von der Leiterschleife (1) eingeschlossene Fläche räumlich homogene Änderung des zu messenden Feldes den Strom durch die Magnetfeldquelle (3) ungeändert lässt.

15. Messinstrument nach einem der vorhergehenden Ansprüche, **dadurch gekennzeichnet, dass** das Basismaterial eine Verbindung gemäß der Formel $ZBa_2Cu_3O_{7-x}$, worin Z ein Element aus der Gruppe (Y, Nd, Gd, Ho, Tm, Tb, Dy, Yb, Sm, Er oder Eu) ist, enthält.

16. Messinstrument nach einem der vorhergehenden Ansprüche, **dadurch gekennzeichnet, dass**

     • die Magnetfeldquelle (3) und der Verbraucherbereich (2) als dünne Schichten und/oder
     • die Leiterschleife (1) und die Magnetfeldquelle (3) als dünne Schichten und/oder
     • der Sensor (4) und die Magnetfeldquelle (3) jeweils auf dem gleichen Substrat strukturiert sind oder alternativ auf separaten Substraten strukturiert sind, die mit ihren strukturierten Oberflächen aneinandergefügt sind.

17. Messinstrument nach einem der vorhergehenden Ansprüche, **dadurch gekennzeichnet, dass** der Sensor (4) und die Magnetfeldquelle (3) sich innerhalb einer magnetischen Abschirmung befinden.

18. Messsystem für biomagnetische Messungen, für geomagnetische Messungen, für zerstörungsfreie Materialprüfung und/oder für Materialforschung, **dadurch gekennzeichnet, dass** es ein Messinstrument oder ein elektrisches Widerstandselement nach einem der vorhergehenden Ansprüche enthält.

**Claims**

1. Electrical resistance element with a non-zero resistance value of $10^{-4}$ ohm or less, preferably $10^{-6}$ ohm or less, which comprises a coplanar structure consisting of spaced-apart electrodes (23a, 23b), configured in particular in a meander pattern, electrically connected by a resistance layer (24) of normally conductive metal, wherein the material of the electrodes (23a, 23b) possesses a phase transition to the superconductive state, **characterized in that** the structure has an interdigitating configuration and **in**

**that** the material of the electrodes is a high-temperature superconductor with a transition temperature of over 50 K.

2. Measuring instrument for time-variable magnetic fields or field gradients, with

☐ a flux transformer, said flux transformer having a conductor loop (1) comprising a base material which possesses a phase transition to the superconductive state for converting a time-varying magnetic flux or flux gradient into an electric current, and a magnetic field source (3) fed from this conductor loop for converting the electric current into a magnetic auxiliary field, the material of the magnetic field source being in particular one possessing a phase transition to the superconductive state, and
☐ a sensor (4), which may be in particular a superconductive quantum interferometer SQUID, for the magnetic auxiliary field, the flux transformer having at least one resistive dissipation zone (2) for dissipating the electrical energy in the electric circuit comprising the conductor loop (1) and the magnetic field source (3) even when the base material is in the superconductive state, the conductor loop (1) and the magnetic field source (3) being arranged in one plane and the magnetic field source (3) in particular forming part of the sensor (4),

**characterized in that**

☐ at least one electrical resistance element according to Claim 1 or a tunnel contact with an insulator material which does not possess a phase transition to the superconductive state is provided as dissipation zone (2), and/or
☐ the conductor loop (1) and the magnetic field source (3) are structured on separate substrates which are joined to each other and electrically connected by their structured surfaces, one or both substrates bearing a normally conductive layer which forms the dissipation zone (2), the base material being a high-temperature superconductor with a transition temperature of over 50 K.

3. Measuring instrument according to the preceding claim, **characterized in that** the dissipation zone (2) has a normally conductive metal from the group comprising silver, gold, platinum, and alloys thereof.

4. Measuring instrument according to any one of the preceding claims, **characterized in that** the tunnel contact (22) between the electrodes (21a, 21b) forming the layered stack has an insulator material from the group comprising $AlO_x$, MgO, AlN, MgO-NiO-

MgO, $PrBa_2Cu_3O_{7-x}$, or $SrTiO_3$, the conductor loop (1) and/or the magnetic field source (3) being in particular configured as thin films with a thickness of 1 $\mu$m or less.

5. Measuring instrument according to any one of the preceding claims, **characterized in that** the conductor loop (1), or "pickup coil", and/or the magnetic field source (3), or "coupling coil", are coils each with at least one turn,

☐ the pickup coil (1) preferably having a diameter of 1 cm or more, preferably 3 cm or more, and most preferably 5 cm or more, and/or
☐ the coupling coil (3) preferably having a diameter of 3 mm or less.

6. Measuring instrument according to the preceding claim, **characterized in that** the ratio between the diameters of the coupling coil (3) and the pickup coil (1) is not more than 0.1.

7. Measuring instrument according to either of the two preceding claims, **characterized in that** the coupling coil (3) has between 80% and 120% of the inductance of the pickup coil (1); in particular, the inductances of the pickup coil (1) and coupling coil (3) may be equal.

8. Measuring instrument according to any one of the three preceding claims, **characterized in that** the ratio between the number of turns of the coupling coil (3) and pickup coil (1) is not less than the square root of the ratio between the diameters of the coupling coil (3) and pickup coil (1).

9. Measuring instrument according to any one of the preceding claims, **characterized in that** the magnetic field source (3) is arranged at least partly inside the region surrounded by the conductor loop (1).

10. Measuring instrument according to any one of the preceding claims, **characterized in that** the dissipation zone (2) has an electrical resistance of between $10^{-11}$ ohm and $10^{-5}$ ohm, and in particular between $10^{-11}$ ohm and $10^{-6}$ ohm.

11. Measuring instrument according to any one of the preceding claims, **characterized in that** the flux transformer has an inductance of between 1 nH and 1 mH, and in particular between 10 nH and 100 $\mu$H.

12. Measuring instrument according to any one of the preceding claims, **characterized in that** an electric current circulating in the flux transformer has a relaxation time *tau*, at least when the base material is in the superconductive state, of between 1 ms and $10^6$ s, and in particular between 3 ms and 300 s.

**13.** Measuring instrument according to any one of the preceding claims, **characterized in that** the transfer function of the flux transformer which describes the conversion of the field or field gradient to be measured into the auxiliary field is a high-pass filter, in particular one having a cut-off frequency $f_0$ of between 1 $\mu$Hz and 1 kHz, and in particular between 3 mHz and 300 Hz, the transfer function of the flux transformer which describes the conversion of the flux to be measured into the auxiliary field preferably being conductive for frequencies between the cut-off frequency $f_0$ of the high-pass filter and 1 MHz.

**14.** Measuring instrument according to any one of the preceding claims, **characterized in that** the conductor loop (1) and magnetic field source (3) are interconnected so that a change in the field to be measured that is spatially uniform over the area enclosed by the conductor loop (1) leaves the current through the magnetic field source (3) unchanged.

**15.** Measuring instrument according to any one of the preceding claims, **characterized in that** the base material contains a compound according to the formula $ZBa_2Cu_3O_{7-x}$, where Z is an element from the group comprising yttrium, neodymium, gadolinium, holmium, thulium, terbium, dysprosium, ytterbium, samarium, erbium, and europium.

**16.** Measuring instrument according to any one of the preceding claims, **characterized in that**

☐ the magnetic field source (3) and the dissipation zone (2), in the form of thin films, and/or
☐ the conductor loop (1) and the magnetic field source (3), in the form of thin films, and/or
☐ the sensor (4) and the magnetic field source (3)

are in each case structured on the same substrate or alternatively on separate substrates joined to each other by their structured surfaces.

**17.** Measuring instrument according to any one of the preceding claims, **characterized in that** the sensor (4) and the magnetic field source (3) are located inside a magnetic screen.

**18.** Measuring system for biomagnetic measurements, geomagnetic measurements, nondestructive materials testing and/or materials research, **characterized in that** it includes a measuring instrument or electrical resistance element according to any one of the preceding claims.

**Revendications**

**1.** Elément de résistance électrique avec une valeur de résistance différente de zéro de $10^{-4}$ $\Omega$ ou moins, de préférence de $10^{-5}$ $\Omega$ ou moins, lequel comprend une structure coplanaire d'électrodes (23a, 23b) espacées les unes des autres, en particulier réalisées en forme de méandres, lesquelles sont reliées électriquement grâce à une couche de résistance (24) en un métal normalement conducteur, dans lequel le matériau des électrodes (23a, 23b) possède une transition de phase vers l'état supraconducteur, **caractérisé en ce que** la structure est réalisée de manière interdigitante et **en ce que** le matériau des électrodes est un supraconducteur à haute température avec une température de transition de plus de 50 K.

**2.** Instrument de mesure pour champs magnétiques ou gradients de champ variables dans le temps avec

- un transformateur de flux, dans lequel ce transformateur de flux possède une boucle conductrice (1) comprenant un matériau de base qui a une transition de phase vers l'état supraconducteur pour transformer un flux magnétique ou gradient de flux variable dans le temps en un courant électrique ainsi qu'une source de champ magnétique (3) alimentée à partir de cette boucle conductrice pour transformer le courant électrique en un champ magnétique auxiliaire, dans lequel le matériau de la source de champ magnétique peut en particulier avoir une transition de phase vers l'état supraconducteur, et
- un capteur (4), lequel peut en particulier être un interféromètre quantique supraconducteur, SQUID, pour le champ magnétique auxiliaire, dans lequel le transformateur de flux présente, également lorsque le matériau de base se trouve à l'état supraconducteur, au moins une zone de consommation résistive (2) pour la dissipation de l'énergie électrique dans le circuit électrique qui comprend la boucle conductrice (1) et la source de champ magnétique (3), dans lequel la boucle conductrice (1) et la source de champ magnétique (3) sont disposées dans un plan et dans lequel la source de champ magnétique (3) peut en particulier être une partie du capteur (4), **caractérisé en ce que**
- au moins un élément de résistance électrique selon la revendication 1 ou une jonction à effet tunnel avec un matériau isolant, lequel ne possède pas de transition de phase vers l'état supraconducteur, est prévu(e) en tant que zone de consommation (2), et/ou
- la boucle conductrice (1) et la source de champ magnétique (3) sont structurées sur des substrats séparés, lesquels sont assemblés avec leurs surfaces structurées et sont connectés électriquement, dans lequel, sur un substrat ou sur les deux substrats, une couche normalement conductrice est disposée, laquelle forme la zone de consommation (2), dans lequel le matériau de base est un supraconducteur à haute température avec une température de transition de plus de 50 K.

3. Instrument de mesure selon la revendication précédente, **caractérisé en ce que** la zone de consommation (2) présente un métal normalement conducteur du groupe Ag, Au, Pt ou de leurs alliages.

4. Instrument de mesure selon l'une des revendications précédentes, **caractérisé en ce que** la jonction à effet tunnel (22) présente, entre les électrodes (21a, 21b) formant la pile de couches, un matériau isolant du groupe $AlO_x$, MgO, AlN, MgO-NiO-MgO, $PrBa_2Cu_3O_{7-x}$ ou $SrTiO_3$, dans lequel la boucle conductrice (1) et/ou la source de champ magnétique (3) peuvent en particulier être réalisées en tant que couches minces avec une épaisseur de couche de 1 $\mu$m ou moins.

5. Instrument de mesure selon l'une des revendications précédentes, **caractérisé en ce que** la boucle conductrice (1), la « bobine réceptrice », et/ou la source de champ magnétique (3), la « bobine de couplage », sont des bobines avec respectivement au moins un enroulement, dans lequel, de manière préférée,

   - la bobine réceptrice (1) peut présenter un diamètre de 1 cm ou plus, de préférence de 3 cm ou plus et de manière particulièrement préférée, de 5 cm ou plus, et/ou
   - la bobine de couplage (3) peut présenter un diamètre de 3 mm ou moins.

6. Instrument de mesure selon la revendication précédente, **caractérisé en ce que** le rapport des diamètres entre la bobine de couplage (3) et la bobine réceptrice (1) est de 0,1 tout au plus.

7. Instrument de mesure selon l'une des deux revendications précédentes, **caractérisé en ce que** la bobine de couplage (3) présente entre 80 % et 120 % de l'inductance de la bobine réceptrice (1), dans lequel en particulier la bobine réceptrice (1) et la bobine de couplage (3) peuvent présenter des inductances identiques.

8. Instrument de mesure selon l'une des trois revendications précédentes, **caractérisé en ce que** le rapport des nombres d'enroulement entre la bobine de couplage (3) et la bobine réceptrice (1) est au moins aussi grand que la racine carrée du rapport des diamètres entre la bobine de couplage (3) et la bobine réceptrice (1).

9. Instrument de mesure selon l'une des revendications précédentes, **caractérisé en ce que** la source de champ magnétique (3) est disposée au moins partiellement à l'intérieur de la zone enfermée par la boucle conductrice (1).

10. Instrument de mesure selon l'une des revendications précédentes, **caractérisé en ce que** la zone de consommation (2) présente une résistance électrique entre $10^{-11}$ $\Omega$ et $10^{-5}$ $\Omega$, en particulier entre $10^{-11}$ $\Omega$ et $10^{-6}$ $\Omega$.

11. Instrument de mesure selon l'une des revendications précédentes, **caractérisé en ce que** le transformateur de flux présente une inductance entre 1 nH et 1 mH, en particulier entre 10 nH et 100 $\mu$H.

12. Instrument de mesure selon l'une des revendications précédentes, **caractérisé en ce qu'**un courant électrique circulant dans le transformateur de flux possède, au moins lorsque le matériau de base se trouve à l'état supraconducteur, un temps de relaxation $\tau$ entre 1 ms et $10^6$ s, en particulier entre 3 ms et 300 s.

13. Instrument de mesure selon l'une des revendications précédentes, **caractérisé en ce que** la fonction de transfert du transformateur de flux, laquelle décrit la conversion du champ ou du gradient de champ à mesurer pour donner le champ auxiliaire, est un filtre passe-haut, qui peut en particulier présenter une fréquence de coupure $f_0$ entre 1 $\mu$Hz et 1 kHz, en particulier entre 3 mHz et 300 Hz, dans lequel, de manière préférée, la fonction de transfert du transformateur de flux, laquelle décrit la conversion du flux à mesurer pour donner le champ auxiliaire, peut être perméable pour des fréquences entre la fréquence de coupure $f_0$ du filtre passe-haut et 1 MHz.

14. Instrument de mesure selon l'une des revendications précédentes, **caractérisé en ce que** la boucle conductrice (1) et la source de champ magnétique (3) sont interconnectées de telle manière qu'une modification spatialement homogène, sur la surface enfermée par la boucle conductrice (1), du champ à mesurer ne modifie pas le courant à travers la source de champ magnétique (3).

15. Instrument de mesure selon l'une des revendications précédentes, **caractérisé en ce que** le matériau de base contient une combinaison selon la formule $ZBa_2CU_3O_{7-x}$, Z étant un élément du groupe (Y, Nd, Gd, Ho, Tm, Tb, Dy, Yb, Sm, Er ou Eu).

16. Instrument de mesure selon l'une des revendications précédentes, **caractérisé en ce que**

- la source de champ magnétique (3) et la zone de consommation (2), en tant que couches minces, et/ou
- la boucle conductrice (1) et la source de champ magnétique (3), en tant que couches minces, et/ou
- le capteur (4) et la source de champ magnétique (3)

sont respectivement structurés sur le même substrat ou bien sont structurés, en variante, sur des substrats séparés, lesquels sont assemblés avec leurs surfaces structurées.

17. Instrument de mesure selon l'une des revendications précédentes, **caractérisé en ce que** le capteur (4) et la source de champ magnétique (3) se trouvent à l'intérieur d'une protection magnétique.

18. Système de mesure pour mesures biomagnétiques, pour mesures géomagnétiques, pour essais de matériaux non destructifs et/ou pour des recherches sur des matériaux, **caractérisé en ce qu'**il comprend un instrument de mesure ou un élément de résistance électrique selon l'une des revendications précédentes.

**1**

**2** **3** **4**

Figur 1

**21a**

**22**

**21b**

Figur 2a

Figur 2b

Figur 2c

Figur 3a

Figur 3b

Figur 4a

Figur 4b

Figur 4c

Figur 4d

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Nicht-Patentliteratur**

- **J. E. ZIMMERMANN ; N. V. FREDERICK.** Miniature Ultrasensitive Superconducting Magnetic Gradiometer and Its Use in Cardiography and Other Applications. *Appl. Phys. Lett.,* 1971, vol. 19, 16
- **T. Q. YANG ; KENICHIRO YAO ; DAISUKE YAMASKI ; KEIJI ENPUKU.** Magnetometer utilizing SQUID picovoltmeter and cooled normal pickup coil. *Physica C,* 2005, vol. 426-431, 1596-1600

- **D. F. HE ; H. ITOZAKI ; M. TACHIKI.** Improving the sensitivity of a high-TC SQUID at MHz frequency using a normal metal transformer. *Superconductor Science and Technology,* 2006, vol. 19, S231-S234
- **H. DYVORNE, J. SCOLA ; C. FERMON ; J. F. JACQUINOT ; M. PANNETIER-LECOEUR.** Flux transformers made of commercial high critical temperature superconducting wires. *Review of Scientific Instruments,* 2008, vol. 79, 025107